# EUROPEAN PATENT APPLICATION

(11) **EP 1 467 433 A1**
(43) Date of publication of application: **13.10.2004**
(21) Application number: 04007813.1
(22) Date of filing: 31.03.2004
(51) Int. Cl.: H01Q 1/24, H01Q 1/42, H05K 5/06, H05K 5/00

(54) **Converter for satellite broadcasting reception**

(30) Priority: 10.04.2003 JP 2003106714
(71) Applicant: Alps Electric Co., Ltd., Tokyo 145-8501 (JP)
(72) Inventor: Suzuki, Shigetaka, Ota-ku Tokyo 145-8501 (JP); Matsuzaki, Satoru, Ota-ku Tokyo 145-8501 (JP)
(74) Representative: Klunker . Schmitt-Nilson . Hirsch

(57) **Abstract**

A converter for satellite broadcasting reception is disclosed that is capable of ensuring sufficient waterproofness with high productivity at a low cost. The converter for satellite broadcasting reception comprises a main body portion 1 in which a circuit board is accommodated, a horn portion 2 protruding from the main body 1, connectors 3 protruding from the main body 1, and a package member 4 made of a flexible insulating material. The package member 4, which is in a sealed state, accommodates the main body 1 and the horn portion 2, with at least parts of the connectors 3 being exposed to the outside of the package member. As a result, compared with a conventional technology, it is possible to obtain sufficient waterproofness for the main body 1 or the horn portion 2.

## Description

### BACKGROUND OF THE INVENTION

### 1. Field of the Invention

The present invention relates to a converter for satellite broadcasting reception to receive a satellite broadcast.

### 2. Description of the Related Art

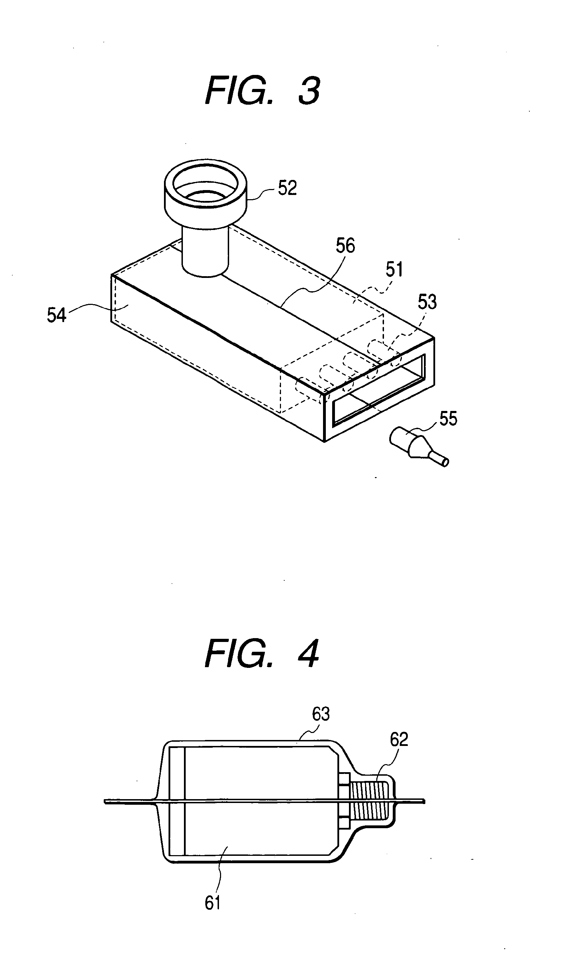

The configuration of a conventional converter for satellite broadcasting reception, as shown in Fig. 3, will be described. In a box-shaped main body 51, which is made of a metallic material, a circuit board (not shown) comprising a desired circuit (receiving circuit) is accommodated. The main body 51 is provided with a horn portion 52 and female coaxial connectors 53 in a state of being protruding to the outside of the main body.

A cover 54 made of a synthetic resin molding is attached to the main body 51 to cover the main body 51 and the connectors 53, and male coaxial connectors 55 are connected to the connectors 53. As a result, the connectors 55 leads a satellite broadcast from the converter for satellite broadcasting reception, which is located outdoors, is electrically connected to a tuner (not shown) located indoors.

In addition, the cover 54 of the converter for satellite broadcasting reception, which is located outdoors, provides waterproof protection of the main body 51 and the connector 53 (for example, see Japanese Unexamined Patent Application Publication No. 11-46149).

However, in the converter for satellite broadcasting reception, although an adhesive 56 is applied to a joint of the cover 54 to ensure sufficient waterproof protection of the main body 51, the work thereof is troublesome and, consequently, productivity thereof deteriorates. In addition, when the adhesive 56 is applied and then dries, a gap occasionally forms in the joint of the cover 54, resulting in insufficient waterproofness of the cover 54. In addition, since the horn portion 52 is exposed from the cover 54, the horn portion 52, too, is not sufficiently waterproof.

In addition, the configuration of a conventional converter for satellite broadcasting reception, as shown in Fig. 4, will be described. The converter for satellite broadcasting reception comprises a main body 61, connectors 62, and a horn portion (not shown). The entire converter for satellite broadcasting reception is covered with a package member 63, creating a sealed state, wherein such package member 63 is made of an insulating material (for example, see Japanese Unexamined Patent Application Publication No. 5-327320).

However, the conventional converter for satellite broadcasting reception, as shown Fig. 4, is made to be waterproof by way of the package member 63 until the converter is shipped from a manufacturing factory to an end user (about several months). Upon receipt of the package member 63, the end user tears the package member 63 to pieces and then takes the converter for satellite broadcasting reception out of the package member. The converter for satellite broadcasting reception is then placed outdoors.

Accordingly, since the converter for satellite broadcasting reception, which is placed outdoors, has a structure that is not sufficiently waterproof, it is required that the converter for satellite broadcasting reception have a waterproof structure such as a cover.

When the conventional converter for satellite broadcasting reception is employed outdoors, the converter is used after taking it out of a waterproof structure, such as the cover 54, or the package member. As a result, it is difficult to ensure sufficient waterproofness, and it is required that strict bonding work of the cover 54 be performed. Accordingly, there is a problem in that productivity thereof deteriorates and the cost thereof increases.

### SUMMARY OF THE INVENTION

Accordingly, it is an object of the present invention to provide a converter for satellite broadcasting reception that is capable of ensuring sufficient waterproofness with high-productivity process at a low cost.

As a first means to achieve the above object, a converter for satellite broadcasting reception, comprises: a main body in which a circuit board is accommodated; a horn portion protruding from the main body; connectors protruding from the main body; and a package member made of a flexible insulating material, wherein the package member, which is in a sealed state, accommodates the main body and the horn portion, with at least parts of the connectors being exposed to the outside of the package member.

As a second means to achieve the above object, the converter for satellite broadcasting reception further comprises a cover made of a synthetic resin molding, wherein the outer peripheral portion of the package member is covered with the cover.

As a third means to achieve the above object, the entire outer peripheral portion of the package member is covered with the cover.

As a fourth means to achieve the above object, a deflation process is carried out in the inside of the package member.

As a fifth means to achieve the above object, a seam of the package member and/or a joint between the package member and the connectors are bonded by thermocompression.

### BRIEF DESCRIPTION OF THE DRAWINGS

Fig. 1 is a perspective view illustrating a converter for satellite broadcasting reception according to the present invention;
Fig. 2 is a perspective view illustrating a converter for satellite broadcasting reception according to the present invention in a state that a cover is detached;
Fig. 3 is a perspective view illustrating a conventional converter for satellite broadcasting reception;
Fig. 4 is an exterior view illustrating a conventional converter for satellite broadcasting reception.

### DESCRIPTION OF THE PREFERRED EMBODIMENTS

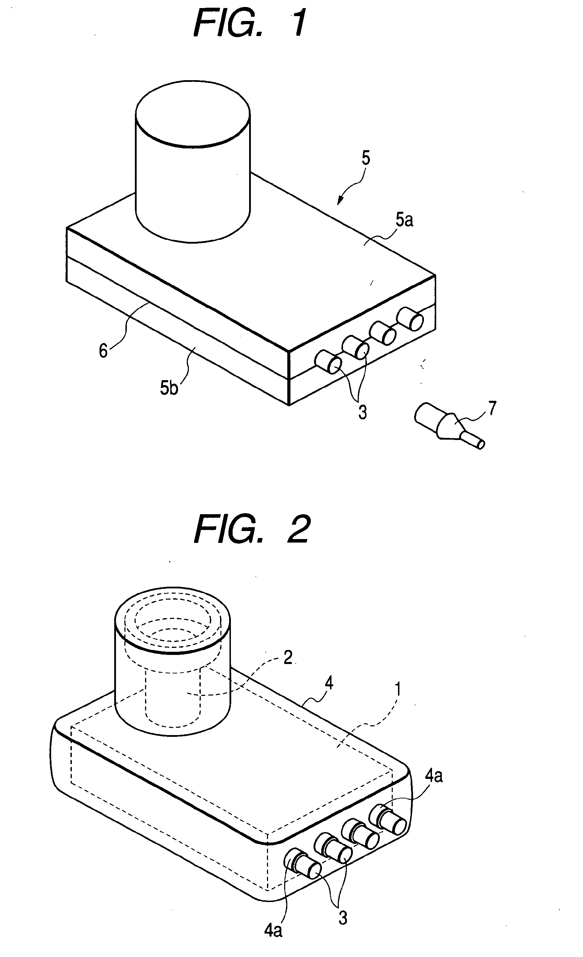

Now, a converter for satellite broadcasting reception according to the present invention will be described with reference to the drawings. Fig. 1 is a perspective view illustrating a converter for satellite broadcasting reception according to the present invention. Fig. 2 is a perspective view illustrating a converter for satellite broadcasting reception, according to the present invention, in a state in which a cover is detached.

Further, a configuration of a converter for satellite broadcasting reception according to the present invention will be described with reference to Fig. 1 and Fig. 2. In a box-shaped main body 1, which is made of a metallic material, a circuit board (not shown) comprising a desired circuit (receiving circuit) is accommodated.

In addition, in a state in which a horn portion 2 protrudes from the upper portion of the main body 1 to the outside thereof, the horn portion 2 is combined with the main body 1, and, in a state in which a plurality of female coaxial connectors 3 protrude from the lateral side of the main body 1 to the outside thereof, the connectors 3 are combined with the main body 1.

A package member 4, which is made of flexible, plastic insulating materials such as polyester, nylon, polypropylene, etc., forms a bag shape. The package member 4 covers the main body 1 and the horn portion 2, with at least parts (tips) of the connectors 3 being exposed to the outside, and the inside of the package member 4, in which the main body 1 and the horn portion 2 are accommodated, is in a sealed state.

In addition, in the inside of the package member 4, in which the main body 1 and the horn portion 2 are accommodated, a deflation process is carried out. Further, a seam (not shown) of the package member 4 and a joint 4a between the package member 4 and the connectors 3 are bonded by thermocompression.

In addition, in this embodiment, although the package member 4 is bonded by thermocompression, it may be bonded with an adhesive.

In addition, a cover 5, made of a synthetic resin molding, includes a first cover 5a for covering the upper portion of the main body 1 and the horn portion 2, and a second cover 5b for covering the lower portion of the main body 1. In addition, the cover 5 covers the entire outer peripheral portion of the package member 4, and covers the main body 1 and the horn portion 2, with part of the connectors 3 protruding to the outside of the cover 5.

In the cover 5, an adhesive 6 is applied to a joint, which is a seam between the first and second covers 5a, 5b, and then the first and second covers 5a, 5b are combined with each other.

In addition, the cover 5 prevents the package member 4 from breaking due to external force. Although the adhesive 6 for combining the first and second covers 5a, 5b with each other is not applied sufficiently, the package member 4 provides sufficient waterproofness for the main body 1 or the horn portion 2.

That is, the cover 5 does not require strict bonding work, but requires only simple bonding work for combining the first and second covers 5a, 5b with each other.

In addition, the cover 5 is not limited thereto, and a variety of configurations may be employed.

Although the converter for satellite broadcasting reception according to the present invention is formed according to the above configuration, the converter for satellite broadcasting reception is placed outdoors, and male coaxial connectors 7 are connected to the connectors 3. As a result, the connectors 7 leads a satellite broadcast from the converter for satellite broadcasting reception, which is located outdoors, to a tuner (not shown) located indoors.

In addition, the converter for satellite broadcasting reception according to the present invention is made to be waterproof by way of the package member 63 until it is shipped from a manufacturing factory to an end user(several months), with the converter being protected by the package member 4 and the cover 5. Upon receipt by the end user, the converter for satellite broadcasting reception is placed outdoors, with the converter being protected by the package member 4 and the cover 5.

In addition, in the above embodiment, although the entire package member 4 may be protected by the cover 5, only a part of the package member 4 may be protected by the cover 5, or the cover 5 may be eliminated as needed.

The converter for satellite broadcasting reception according to the present invention comprises a main body in which a circuit board is accommodated; a horn portion protruding from the main body; connectors protruding from the main body; and a package member made of a flexible insulating material. The package member, which is in a sealed state, accommodates the main body and the horn portion, with at least parts of the connectors being exposed to the outside of the package member. As a result, compared to the conventional technology, the waterproofness of the main body and the horn portion can be ensured.

In addition, the present invention does not require the conventional strict bonding work to bond the covers to each other, and therefore it is possible to obtain the converter with high-productivity at a low cost.

The converter for satellite broadcasting reception comprises a cover made of a synthetic resin molding, and the outer peripheral portion of the package member is covered with the cover. As a result, it is possible to prevent the package member from breaking due to external force and it is possible to ensure a waterproof structure. In addition, the cover does not require a strict bonding work, but requires only simple bonding work.

In addition, the entire outer peripheral portion of the package member is covered with the cover. As a result, it is possible to prevent the package member from breaking due to external force and it is possible to ensure a waterproof structure.

In addition, a deflation process is carried out in the inside of the package member. As a result, it is possible to prevent the main body and the horn portion from being rusted and corroded due to air inside the package member.

In addition, a seam of the package member and/or a joint between the package member and the connectors are bonded by thermocompression. As a result, the work thereof is simple and is excellent in productivity. In addition, it is possible to ensure a sealing structure in the inside of the package member.

## Claims

1. A converter for satellite broadcasting reception, comprising:
a main body in which a circuit board is accommodated;
a horn portion protruding from the main body;
connectors protruding from the main body; and
a package member made of a flexible insulating material,
wherein the package member, which is in a sealed state, accommodates the main body and the horn portion, with at least parts of the connectors being exposed to the outside of the package member.

2. The converter for satellite broadcasting reception according to Claim 1, further comprising:
a cover made of a synthetic resin molding,
wherein the outer peripheral portion of the package member is covered with the cover.

3. The converter for satellite broadcasting reception according to Claim 2,
wherein the entire outer peripheral portion of the package member is covered with the cover.

4. The converter for satellite broadcasting reception according to any one of Claims 1 to 3,
wherein a deflation process is carried out in the inside of the package member.

5. The converter for satellite broadcasting reception according to any one of Claims 1 to 4,
wherein a seam of the package member and/or a joint between the package member and the connectors are bonded by thermocompression.
